# EUROPEAN PATENT APPLICATION

(11) **EP 4 625 479 A1**
(43) Date of publication of application: **01.10.2025**
(21) Application number: 25159218.4
(22) Date of filing: 20.02.2025
(51) Int. Cl.: H01L 21/66

(54) **DETECTION OF PARTICLES ON A SURFACE DURING SEMICONDUCTOR DEVICE MANUFACTURE**

(30) Priority: 29.03.2024 US 202418622714
(71) Applicant: INTEL Corporation, Santa Clara, CA 95054 (US)
(72) Inventor: YEH, Weiming, Portland, OR 97229 (US); FIRBY, Curtis, Hillsboro, OR 97123 (US); WANG, Hsiao-An, Vancouver, WA 98686 (US); PALIWAL, Amit, Beaverton, OR 97006 (US); SINGH, Amit, OR 97123, Hillsboro (US); KRISHNAN, Deepti, Hillsboro, OR 97124 (US); DAKHANE, Akash, Beaverton, OR 97007 (US); SHAH, Smit Alkesh, Portland, OR 97229 (US); RENGARAJAN, Shreya, Hillsboro, OR 97124 (US); BASAK, Amlan, Portland, OR 97229 (US); YEOH, Cher, Hillsboro, OR 97124 (US); CIMMARUSTI, Andres D., Portland, OR 97202 (US)
(74) Representative: HGF

(57) **Abstract**

Chemical mechanical polish processes on surfaces of semiconductor devices comprising tungsten layers can create nano-sized particles of tungsten. These particles can create manufacturing yield reductions. These particles can also be difficult to detect optically. Etched surfaces coated with a layer of material that can provide optical detection enhancement provide an ability to optically detect nano-sized particles.

## Description

### FIELD

Descriptions are generally related to semiconductor manufacturing, and more particular descriptions are related to equipment and methods for detecting particles on a semiconductor wafer surface at points during manufacture.

### BACKGROUND

Semiconductor chips are central to intelligent devices and systems, such as personal computers, laptops, tablets, phones, servers, and other consumer and industrial products and systems. Manufacturing semiconductor chips presents a number of challenges and these challenges are amplified as devices become smaller and performance demands increase. Challenges include, for example, unwanted material interactions, precision and scaling requirements, power delivery requirements, limited failure tolerance, and material and manufacturing costs.

Semiconductor device manufacture involves a large and complicated number of processes to create devices on wafers. Processes include lithographic processes where sacrificial films, e.g., photoresists, are deposited on a surface of the wafer, patterned lithographically with a mask and electromagnetic radiation (e.g., extreme ultraviolet UV light), and developed in the exposed or unexposed regions to allow deposition of materials in selected areas. Wafer surfaces are also planarized and/or polished (e.g., chemical mechanical polishing (CMP)) to remove peaks and/or valleys or other micro- or nano-sized imperfections left behind by other semiconductor manufacturing processes. CMP can also remove surface stresses to aid in preventing warping. CMP can employ slurries of abrasive materials in a liquid in conjunction with spinning of a pad or head and/or spinning of the wafer mounted on a chuck. Abrasive materials include, for example metal oxides such as silicon dioxide, aluminum oxide, iron oxide, and cerium oxide.

### BRIEF DESCRIPTION OF THE DRAWINGS

The figures are provided to aid in understanding the disclosure. The figures can include diagrams and illustrations of examples of structures, assemblies, data, methods, and systems. For ease of explanation and understanding, these structures, assemblies, data, methods, and systems, the figures are not an exhaustively detailed description. The figures therefore should not be understood to depict the entire metes and bounds of structures, assemblies, data, methods, and systems possible without departing from the scope of the disclosure. Additionally, features are not necessarily illustrated relatively to scale due in part to the small sizes of some features and the desire for clarity of explanation in the figures.
**Figure 1** illustrates a defect-causing nano-sized particle of conducting material in a semiconductor device.
**Figures 2A - 2B** show partially manufactured devices that include features for detecting unwanted tungsten particles that can be created during manufacturing processes.
**Figure 3** provides a method for detecting defect-causing nano-sized particles on the surface of an integrated circuit (IC) device.
**Figure 4** illustrates an additional method for detecting defect-causing nano-sized particles on the surface of an integrated circuit (IC) device.
**Figure 5** describes a method for detecting nano-sized particles on the surface of an IC device.
**Figure 6** provides an example of a computing system.

Descriptions of certain details and implementations follow, including non-limiting descriptions of the figures, which depict some examples and implementations.

### DETAILED DESCRIPTION

References to one or more examples are to be understood as describing a particular feature, structure, or characteristic included in at least one implementation. The phrases "one example" or "an example" are not necessarily all referring to the same example or embodiment. Any aspect described herein can potentially be combined with any other aspect or similar aspect described herein, regardless of whether the aspects are described with respect to the same figure or element.

The words "connected" and/or "coupled" can indicate that two or more elements are in direct physical or electrical contact with each other. The term "coupled," however, can also mean that two or more elements are not in direct contact with each other and are instead separated by one or more elements but they may still co-operate or interact with each other, for example, physically, magnetically, optically, or electrically.

The words "first," "second," and the like, do not indicate order, quantity, or importance, but rather are used to distinguish one element from another. The words "a" and "an" herein do not indicate a limitation of quantity, but rather denote the presence of at least one of the referenced items. The terms "follow" or "after" can indicate immediately following or following some other event or events. Other sequences of operations can also be performed according to alternative embodiments. Furthermore, additional operations may be added or removed depending on the application.

Disjunctive language such as the phrase "at least one of X, Y, or Z," is used in general to indicate that an element or feature, may be either X, Y, or Z, or any combination thereof (e.g., X, Y, and/or Z). Thus, this disjunctive language should be understood not to imply that certain embodiments require at least one of X, at least one of Y, or at least one of Z to each be present.

Flow diagrams as illustrated herein provide examples of sequences of various process actions. The flow diagrams can indicate operations to be executed by a software or firmware routine, as well as physical operations. Physical operations can be performed by semiconductor processing equipment. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted and not all implementations will perform all actions.

Various components described can be a means for performing the operations or functions described. Each component described can include software, hardware, or a combination of these. Some components can be implemented as software modules, hardware modules, special-purpose hardware (for example, application specific hardware, application specific integrated circuits (ASICs), and digital signal processors (DSPs)), embedded controllers, or hardwired circuitry). Other components can be semiconductor processing and/or testing equipment that is able to perform physical operations such as, for example, lithography, probing, material deposition (for example, chemical vapor deposition, atomic layer deposition, physical vapor deposition, electrodeposition, and/or sputtering), chemical mechanical polishing (CMP), and etching.

To the extent various computer operations or functions are described herein, they can be described or defined as software code, instructions, configuration, and/or data. The software content can be provided via an article of manufacture with the content stored thereon, or via a method of operating a communication interface to send data via the communication interface. A machine-readable storage medium can cause a machine to perform the functions or operations described. A machine-readable storage medium includes any mechanism that stores information in a tangible form accessible by a machine (e.g., computing device), such as recordable/non-recordable media (e.g., read only memory (ROM), random access memory (RAM), magnetic disk storage media, optical storage media, flash memory devices). Instructions can be stored on the machine-readable storage medium in a non-transitory form. A communication interface includes any mechanism that interfaces to, for example, a hardwired, wireless, or optical medium to communicate to another device, such as, for example, a memory bus interface, a processor bus interface, an Internet connection, a disk controller.

Terms such as chip, die, IC (integrated circuit) chip, IC die, microelectronic chip, microelectronic die, semiconductor die, semiconductor device, and/or semiconductor chip are interchangeable and refer to a semiconductor device comprising integrated circuits.

Semiconductor chip manufacturing processes are sometimes divided into front end of the line (FEOL) processes and back end of the line (BEOL) processes. Electronic circuits and active and passive devices within the chip, such as for example, transistors, capacitors, resistors, and/or memory cells, are manufactured in what can be referred to as FEOL processes. Memory cells include, for example, electronic circuits for random access memory (RAM), such as static RAM (sRAM), dynamic RAM (DRAM), read only memory (ROM), non-volatile memory, and/or flash memory. FEOL processes can be, for example, complementary metal-oxide semiconductor (CMOS) processes. BEOL processes include metallization of the chip where interconnects are formed in layers and the feature size of the interconnect increases in layers nearer the surface of the semiconductor chip. Interconnects in, for example, semiconductor chips that are integrated into heterogeneous packages (such as, for example, packages that include memory and logic chips), can also include through silicon vias (TSVs) that transverse the semiconductor chip device region. Semiconductor devices that have TSVs can blur distinctions between BEOL and FEOL processes.

Semiconductor chip interconnects can be created by forming a trench or though-layer via by etching a trench or via structure into a dielectric layer and filling the trench or via with metal. Dielectric layers can comprise, for example, low-κ dielectrics, SiO₂, silicon nitride (SiN), silicon carbide (SiC), and/or silicon carbonitride (SiCN). Low-κ dielectrics include for example, fluorine-doped SiO₂, carbon-doped SiO₂, porous SiO₂, porous carbon-doped SiO₂, combinations for the foregoing, and also these materials with gas-filled gaps or bubbles. Dielectric layers that include conducting features can be interlayer dielectric (ILD) features. In general, low-κ dielectrics exhibit a dielectric constant that is less than that of SiO₂.

During semiconductor device manufacture, a vast array of unique structures can be present on the wafer. Complicated interactions can exist between the unique structures that are in the multiple layers on a wafer. Additionally, undesirable impurities can be created during manufacturing processes. For example, nano-sized particles of tungsten can be created by processes, for example, during CMP planarization of a tungsten-containing layer. These nano-sized particles can be spread around (for example during CMP planarization steps) and adhere to device structures. Nano-sized particles of tungsten can be 2 - 5 nm in a first dimension, 10 - 15 nm in a second dimension, and 10 - 30 nm in a third dimension. Nano-sized particles can have dimensions that are less than 30 nm. Since these particles are comprised of tungsten, they can be conducting. It can be the case that conventional optical scan methodologies and toolsets used to monitor inline defects during manufacturing are not capable of detecting these tungsten particles, due to their deep subwavelength size. Defects caused by nano-sized tungsten particles can be yield limiting. A lack of inline visibility for a process defect can delay detection and corrective manufacturing process changes.

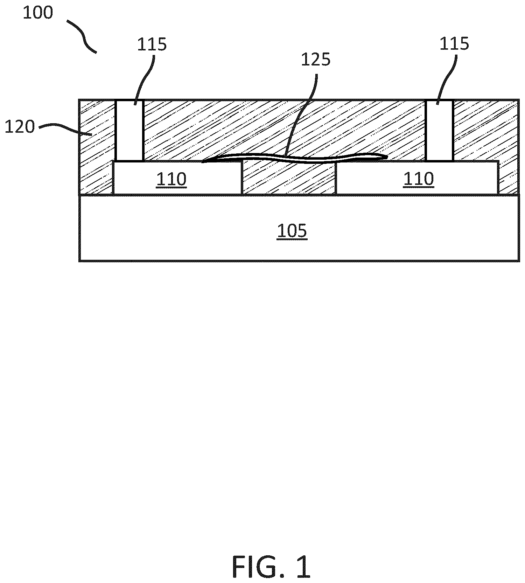

Figure 1 illustrates how an undesirable nano-sized particle of tungsten can create a defect in a semiconductor device. In Figure 1, an exemplary region of a semiconductor device 100 includes a substrate 105, conductive trenches 110, conductive vias 115, and dielectric region 120. Conductive materials that can be in conductive trenches 110 and conductive vias 115 include copper, tungsten, molybdenum, ruthenium, cobalt, or an alloy thereof. Dielectric region 120 can comprise, for example, a low-κ dielectric, silicon dioxide (SiO₂), silicon nitride (SiN), silicon carbide (SiC), and/or silicon carbonitride (SiCN). Low-κ dielectrics have a lower dielectric constant than SiO₂. Low-κ dielectrics include for example, fluorine-doped SiO₂, carbon-doped SiO₂, porous SiO₂, porous carbon-doped SiO₂, combinations for the foregoing, and also these materials with gas-filled gaps. Dielectric layers that include conductive features can be interlayer dielectric (ILD) features. The substrate 105 can include layers that include semiconductor devices, such as transistors and/or memory cells. Semiconductor device 100 also includes a conducting particle of tungsten 125 that is capable of creating an unwanted conductive path between conductive trenches 110. An unwanted shorting conductive path created by a particle defect can render a semiconductor device un-usable. A large number of un-usable devices in a manufacturing run can be an expensive problem.

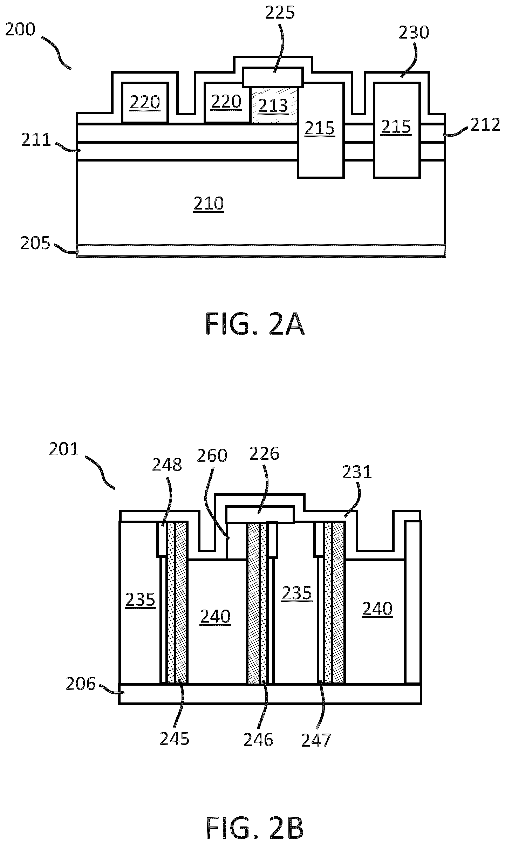

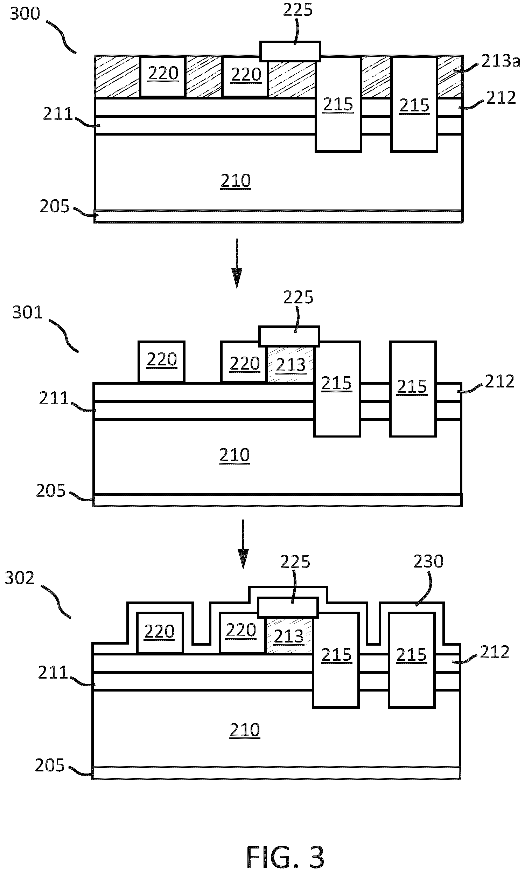

Figures 2A - 2B illustrate partially manufactured semiconductor devices that have been processed in order to determine whether or not tungsten nano-sized particle defects have been created by a manufacturing process. In Figure 2A, structure 200 includes an optional substrate 205 that can be a carrier for the structures used to develop process parameters for manufacturing a section of a semiconductor device. In some example devices, the substrate 205 is comprised of silicon. In the alternative, optional substrate 205 can be a partially manufactured semiconductor device. It is also the case that substrate 205 may not be present. Dielectric region 210 can be a substrate. The dielectric region 210 houses a first dielectric layer 211, a second dielectric layer 212, a third dielectric layer 213, vias 215 and 220. Vias 215 and 220 can be vias in which one connects to gates and one connects to the source/drain of a transistor. Vias 215 and 220 can each have a surface that is in the same plane, and the surfaces can be in the same plane as the surface of the device and part of (in) the surface of the semiconductor device. One or both of vias 215 and 220 can also be trenches in alternative example devices. Dielectric materials can be, for example, a low-κ dielectric, silicon dioxide (SiO₂), silicon nitride (SiN), silicon carbide (SiC), silicon oxycarbide (SiOₓC_{y}), silicon oxynitride (SiOₓN_{y}) and/or silicon carbonitride (SiCN). Low-κ dielectrics have a lower dielectric constant than SiO₂. Low-κ dielectrics include for example, fluorine-doped SiO₂, carbon-doped SiO₂, porous SiO₂, porous carbon-doped SiO₂, combinations for the foregoing, and also these materials with gas-filled gaps. In an example device, dielectric region 210 is comprised of SiO₂, first dielectric layer 211 is SiN, second dielectric layer 212 is SiC, and third dielectric layer 213 (213a) is an ILD material, such as a low-κ dielectric. Third dielectric layer 213 is a partial layer since it is what has remained under a tungsten nano-sized particle 225 after an etch process that removed exposed portions of the dielectric layer 213a (Figure 3).

Vias 215 and 220 contain a conductive material. The conductive material can be copper, tungsten, molybdenum, ruthenium, cobalt, or an alloy thereof. The conductive vias 215 and 220 may also include a first conductive material with one or more layers of a second (or third, etc.) conductive material. In one example, at least one conductive via 215 or 220 is comprised of tungsten. Structure 200 also includes an exposed optical enhancement layer 230 on the surface. The optical enhancement layer 230 improves the surface topography and scatters more light into a detector, so that the tungsten nano-sized particle 225 can be detected optically. The optical enhancement layer 230 can be comprised, for example, of TiN, Ta, aluminum oxide, or titanium oxide. In general, the optical enhancement layer 230 is a material that has a higher optical refractive index than the materials that comprise the surface of the semiconductor device. The optical enhancement layer 230 can also be one that is metallic and more reflective than the surface of the semiconductor device. The optical enhancement layer can reduce optical noise from underlying layers, thereby improving signal to noise ratio for optical defect inspection. In exemplary devices, there are no additional features or layers above optical enhancement layer 230.

Figure 2B illustrates a different configuration for a partially manufactured semiconductor device that has been prepared for analysis 201. Partially manufactured and prepared semiconductor device 201 includes an optional substrate 206 that can be a carrier for the structures used to develop process parameters for manufacturing a section of a semiconductor device. In the alternative, optional substrate 206 can be a partially manufactured semiconductor device that includes, for example, transistors. It is also the case that substrate 206 may not be present. Contacts 235 and gates 240 can be comprised of conductive material. Contacts 235 and gates 240 can be in the same layer of the semiconductor device. The conductive material can be copper, tungsten, molybdenum, ruthenium, cobalt, or an alloy thereof. The conductive contacts 235 and gates 240 may also include a first conductive material with one or more layers of a second (or third, etc.) conductive material. In one example device, at least one conductive contact 235 or conductive gate 240 is comprised of tungsten. In an additional example device, conductive contact 235 and conductive gate 240 are comprised of tungsten. The contact can be the contact to a source or drain and the gate can be a gate of a transistor structure.

The partially manufactured and prepared semiconductor device 201 also includes spacer regions that are non-conductive regions. In Figure 2B, spacer regions include multiple layers, however a partially manufactured structure can include more or fewer layers. The spacer region in this example includes multiple layers of dielectric materials: a first spacer layer 245, a second spacer layer 246, a third spacer layer, and a fourth spacer layer 247. An additional dielectric region 260, remains under tungsten nano-sized particle 226. The first spacer layer 245, second spacer layer 246, third spacer layer 247, fourth spacer layer 248, and dielectric region 260 can be comprised of dielectric materials, such as, for example, low-κ dielectrics, SiO₂, SiN, TiN, SiC, SiOₓC_{y}, SiOₓN_{y}, and/or SiCN. In an exemplary device, first spacer layer 245 is comprised of SiOₓC_{y}, second spacer layer 246 is comprised of SiN, third spacer layer 247 is comprised of SiOₓC_{y}, fourth spacer layer 248 is comprised of one or more layers of SiOₓN_{y} and/or SiN, and dielectric region 260 is comprised of SiN.

Structure 201 also includes an exposed optical enhancement layer 231 on the surface. In exemplary devices, there are no additional features or layers above optical enhancement layer 231. The optical enhancement layer 231 improves the surface topography and refractive index contrast and scatters more light into a detector, so that the tungsten nano-sized particle 226 can be detected optically. The optical enhancement layer 231 can be comprised, for example, of TiN, Ta, aluminum oxide, or titanium oxide. In general, the optical enhancement layer 231 is a material that has a higher optical refractive index than the materials that comprise the surface of the semiconductor device. The optical enhancement layer 231 can also be one that is metallic and more reflective than the surface of the semiconductor device. The optical enhancement layer can reduce optical noise from underlying layers, thereby improving signal to noise ratio for optical defect inspection. In exemplary devices, there are no additional features or layers above optical enhancement layer 231.

Figure 3 illustrates a method for optically detecting a nano-sized particle on an IC device surface. In Figure 3, the numbering of parts in some cases is the same as the numbering of parts in Figure 2A and descriptions herein for the same-numbered parts for Figure 2A can be used for the same-numbered parts in Figure 3. Partially manufactured IC device 300, includes optional substrate 205, can be a carrier for the structures used to develop process parameters for manufacturing a section of a semiconductor device. The optional substrate 205 can be comprised of silicon. In the alternative, optional substrate 205 can be a partially manufactured semiconductor device. It is also the case that substrate 205 may not be present. Dielectric region 210 can also be a substrate. The dielectric region 210 houses a first dielectric layer 211, a second dielectric layer 212, a third dielectric layer 213a, vias 215 and 220. Dielectric materials can be materials as described for dielectric materials with respect to Figure 2A. Vias 215 and 220 are comprised of a conductive material. The conductive material can be copper, tungsten, molybdenum, ruthenium, cobalt, or an alloy thereof. The conductive vias 215 and 220 may also include a first conductive material with one or more layers of a second (or third, etc.) conductive material. In one example, at least one conductive via 215 or 220 is comprised of tungsten. In an additional example device, conductive vias 215 are comprised of tungsten. During a manufacturing process, such as a chemical mechanical polish process, an undesirable nano-sized particle of tungsten 225 can be created. The chemical mechanical polish process can have been performed on a layer comprising tungsten.

Structure 301 can be created through an etch process that is performed on a surface of partially manufactured IC device 300. The etch process can be, for example, a dry plasma process or a wet chemical etch process. There can be remaining dielectric from layer 213a that is below the particle of tungsten 225 leaving dielectric region 213. A particle of tungsten can shield regions of dielectric layer 213a from an etch process. Structure 302 can be formed by depositing optical enhancement layer 230 on a surface of structure 301. The optical enhancement layer 230 can be comprised, for example, of TiN, Ta, aluminum oxide, or titanium oxide. The optical enhancement layer 230 can be deposited by physical vapor deposition, chemical vapor deposition, or atomic layer deposition.

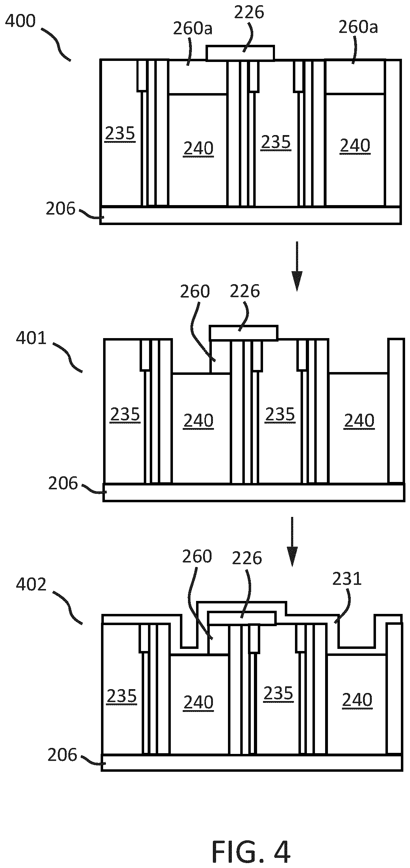

Figure 4 shows an additional method for optically detecting a nano-sized particle on an IC device surface. In Figure 4, the numbering of parts in some instances is the same as the numbering of parts in Figure 2B and descriptions herein for the same-numbered parts for Figure 2B can be used for the same-numbered parts in Figure 4. Partially manufactured IC device 400, includes optional substrate 206, can be a carrier for the structures used to develop process parameters for manufacturing a section of a semiconductor device. The substrate 206 can be comprised of silicon. In the alternative, optional substrate 206 can be a partially manufactured semiconductor device. It is also the case that substrate 206 may not be present. Contacts 235 and gates 240 are comprised of a conductive material. The conductive material can be copper, tungsten, molybdenum, ruthenium, cobalt, or an alloy thereof. The conductive contacts 235 and gates 240 may also include a first conductive material with one or more layers of a second (or third, etc.) conductive material. In one example device, at least one conductive contact 235 or conductive gate 240 is comprised of tungsten. In an additional example device, conductive contacts 235 and conductive gates 240 are comprised of tungsten. The contact can be the contact to a source or drain and the gate can be a gate of a transistor structure. During a manufacturing process, such as a chemical mechanical polish process, an undesirable nano-sized particle of tungsten 226 can be created. The chemical mechanical polish process can have been performed on a layer comprising tungsten.

The partially manufactured IC device 400 also includes spacer regions that are non-conductive regions. Spacer regions can include multiple layers, however a partially manufactured structure can include more or fewer layers. The spacer region in this example includes multiple layers of dielectric materials: a first spacer layer 245, a second spacer layer 246, a third spacer layer, and a fourth spacer layer 247. The partially manufactured IC device 400 includes additional dielectric region 260a which can be a dielectric material as described with respect to dielectric region 260 (Figure 2B).

Structure 401 can be created through an etch process that is performed on a surface of partially manufactured IC device 400. The etch process can be, for example, a dry plasma etch or a wet chemical etch. There can be remaining dielectric from layer 260a that is below the particle of tungsten 226 leaving dielectric region 260. A particle of tungsten can shield regions of dielectric layer 260a from an etch process. Structure 402 can be formed by depositing optical enhancement layer 231 on a surface of structure 401. The optical enhancement layer 231 can be comprised, for example, of TiN, Ta, aluminum oxide, or titanium oxide. The optical enhancement layer 231 can be comprised of a material having a higher optical refractive index than the surface of the device and/or metallic properties. The optical enhancement layer 231 can be deposited by physical vapor deposition, chemical vapor deposition, or atomic layer deposition.

The surfaces of structures 302 and 402, can be scanned by an optical scanner to view particles of tungsten 225 (226) that have been coated with the optical enhancement layer 230 (231). Optical detection can be performed by either bright-field or dark-field illumination, and detection of scattered light into a detector. Automated comparison can be performed between the inspected die and an adjacent reference die to determine a difference in signal indicative of the presence a tungsten particle. The detection of unwanted particles of tungsten 225 (226) that have been created by a process (e.g., a chemical mechanical polish) can allow investigation of processes and the avoidance of processes that cause manufacturing defects. A process recipe can be changed until the number of unwanted particles of tungsten is reduced sufficiently.

In Figures 1, 2A - 2B, 3, and 4, other arrangements of vias, trenches, and dielectric regions are possible.

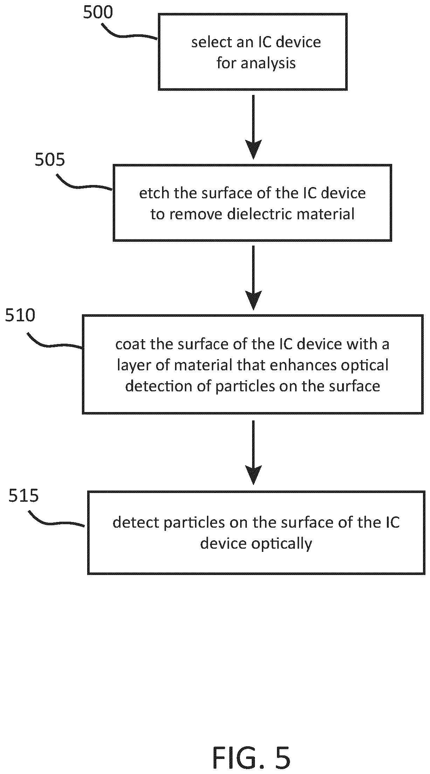

Figure 5 describes a method for detecting particles on the surface of an IC device. The IC device can be any of the devices of Figures 2A - 2B or a different device. The method can be described also by Figures 3 - 4 and the accompanying descriptions. An IC device is selected for analysis 500. The IC device can be one that has been specially created to test chemical mechanical polish recipes. The surface of the IC device is etched 505. The surface of the IC device is coated with a layer of material that can enhance the optical detection of particles on the surface of the device, such as, for example, nano-sized tungsten particles 510. The optical enhancement layer 230 can be comprised, for example, of TiN, Ta, aluminum oxide, or titanium oxide. Particles on the surface of the IC device can be detected optically 515.

Transistors described herein can be field effect transistors. Field effect transistors typically are metal-oxide-semiconductor field-effect (MOSFET) transistors. A semiconductor device can contain more than one type of transistor. A ribbon FET is a type of gate-all-around (GAA) transistor, which can include nanowire FETs and ribbon FETs. Other types of transistors include planar FETs and fin FETs. The devices and methods described herein are not limited to a particular type of transistor that may be part of a partially manufactured or processed partially manufactured semiconductor device.

Semiconductor device substrates or wafers (i.e., 105, 205, or 206) can be, for example, a silicon or silicon-on-insulator substate. Other materials for semiconductor substrates include gallium arsenide, germanium, indium antimonide, lead telluride, indium phosphide, indium antimonide, indium gallium arsenide, or gallium antimonide. Other types of substrates are also possible and the devices described herein are not limited to a particular type of substrate. Devices can be built on a wafer's surface.

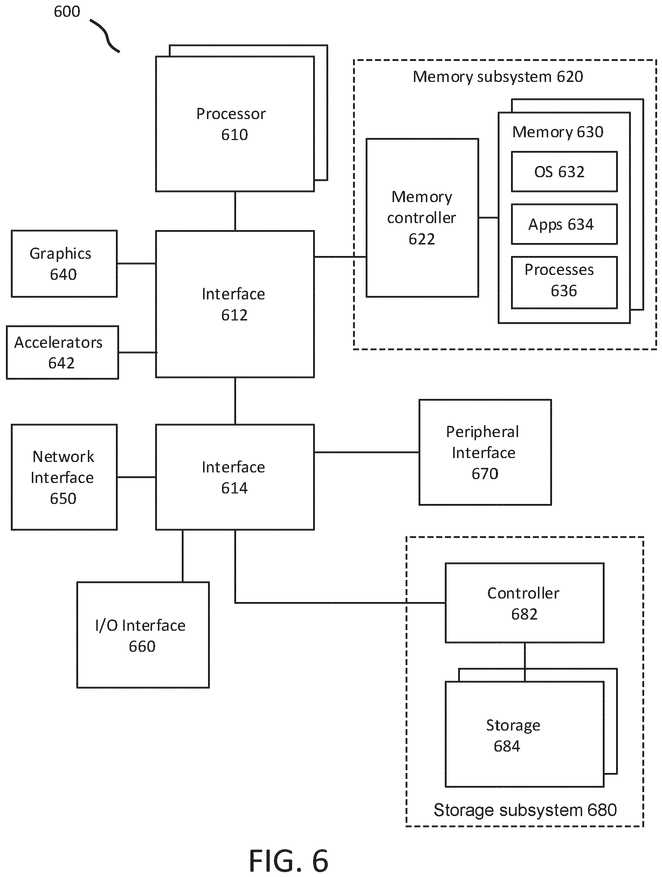

In Figures 1, 2A - 2B, and 3 - 5 the semiconductor devices (or IC devices) can be any combination of microprocessors, CPUs (central processing units), GPUs (graphics processing units), processing cores, system on a chips, other processing hardware, a combination of processors or processing cores, programmable general-purpose or special-purpose microprocessors, accelerators, DSPs, I/O management, programmable controllers, ASICs, programmable logic devices (PLDs), HBM, and/or other memory devices. These semiconductor chip packages can be heterogeneous packages that incorporate different types of chips into one package. The semiconductor chips can be any of the chips, for example, described herein with respect to Figure 6. The semiconductor chip packages described herein generally can be part of various larger package structures and configurations and the foregoing examples are not meant to limit the types of assemblies that are possible.

Figure 6 depicts an example computing system. The computing system can be a system used for running equipment in a semiconductor fabrication plant. For example, instructions for performing one or more aspects of the process described in Figure 3 - 5 can be stored and/or run on the computing system. A computing system 600 can include more, different, or fewer features than the ones described with respect to Figure 6.

Computing system 600 includes processor 610, which provides processing, operation management, and execution of instructions for system 600. Processor 610 can include any type of microprocessor, CPU (central processing unit), GPU (graphics processing unit), processing core, or other processing hardware to provide processing for system 600, or a combination of processors or processing cores. Processor 610 controls the overall operation of system 600, and can be or include, one or more programmable general-purpose or special-purpose microprocessors, DSPs, programmable controllers, ASICs, programmable logic devices (PLDs), or the like, or a combination of such devices.

In one example, system 600 includes interface 612 coupled to processor 610, which can represent a higher speed interface or a high throughput interface for system components needing higher bandwidth connections, such as memory subsystem 620 or graphics interface components 640, and/or accelerators 642. Interface 612 represents an interface circuit, which can be a standalone component or integrated onto a processor die. Where present, graphics interface 640 interfaces to graphics components for providing a visual display to a user of system 600. In one example, the display can include a touchscreen display.

Accelerators 642 can be a fixed function or programmable offload engine that can be accessed or used by a processor 610. For example, an accelerator among accelerators 642 can provide data compression (DC) capability, cryptography services such as public key encryption (PKE), cipher, hash/authentication capabilities, decryption, or other capabilities or services. In some cases, accelerators 642 can be integrated into a CPU socket (e.g., a connector to a motherboard (or circuit board, printed circuit board, mainboard, system board, or logic board) that includes a CPU and provides an electrical interface with the CPU). For example, accelerators 642 can include a single or multi-core processor, graphics processing unit, logical execution unit single or multi-level cache, functional units usable to independently execute programs or threads, application specific integrated circuits (ASICs), neural network processors (NNPs), programmable control logic, and programmable processing elements such as field programmable gate arrays (FPGAs) or programmable logic devices (PLDs). Accelerators 642 can provide multiple neural networks, CPUs, processor cores, general purpose graphics processing units, or graphics processing units can be made available for use by artificial intelligence (AI) or machine learning (ML) models.

Memory subsystem 620 represents the main memory of system 600 and provides storage for code to be executed by processor 610, or data values to be used in executing a routine. Memory subsystem 620 can include one or more memory devices 630 such as read-only memory (ROM), flash memory, one or more varieties of random access memory (RAM) such as static RAM (SRAM), dynamic RAM (DRAM), synchronous DRAM (SDRAM) and/or or other memory devices, or a combination of such devices. Memory 630 stores and hosts, among other things, operating system (OS) 632 that provides a software platform for execution of instructions in system 600, and stores and hosts applications 634 and processes 636. In one example, memory subsystem 620 includes memory controller 622, which is a memory controller to generate and issue commands to memory 630. The memory controller 622 can be a physical part of processor 610 or a physical part of interface 612. For example, memory controller 622 can be an integrated memory controller, integrated onto a circuit within processor 610.

System 600 can also optionally include one or more buses or bus systems between devices, such memory buses, graphics buses, and/or interface buses. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a peripheral component interface (PCI) or PCI express (PCIe) bus, a Hyper Transport or industry standard architecture (ISA) bus, a small computer system interface (SCSI) bus, a universal serial bus (USB), or a Firewire bus.

In one example, system 600 includes interface 614, which can be coupled to interface 612. In one example, interface 614 represents an interface circuit, which can include standalone components and integrated circuitry. In one example, user interface components or peripheral components, or both, couple to interface 614. Network interface 650 provides system 600 the ability to communicate with remote devices (e.g., servers or other computing devices) over one or more networks. Network interface 650 can include an Ethernet adapter, wireless interconnection components, cellular network interconnection components, USB, or other wired or wireless standards-based or proprietary interfaces. Network interface 650 can transmit data to a device that is in the same data center or rack or a remote device, which can include sending data stored in memory.

Some examples of network interface 650 are part of an infrastructure processing unit (IPU) or data processing unit (DPU), or used by an IPU or DPU. An xPU can refer at least to an IPU, DPU, GPU, GPGPU (general purpose computing on graphics processing units), or other processing units (e.g., accelerator devices). An IPU or DPU can include a network interface with one or more programmable pipelines or fixed function processors to perform offload of operations that can have been performed by a CPU. The IPU or DPU can include one or more memory devices.

In one example, system 600 includes one or more input/output (I/O) interface(s) 660. I/O interface 660 can include one or more interface components through which a user interacts with system 600 (e.g., audio, alphanumeric, tactile/touch, or other interfacing). Peripheral interface 670 can include additional types of hardware interfaces, such as, for example, interfaces to semiconductor fabrication equipment and/or electrostatic charge management devices.

In one example, system 600 includes storage subsystem 680. Storage subsystem 680 includes storage device(s) 684, which can be or include any conventional medium for storing data in a nonvolatile manner, such as one or more magnetic, solid state, and/or optical based disks. Storage 684 can be generically considered to be a "memory," although memory 630 is typically the executing or operating memory to provide instructions to processor 610. Whereas storage 684 is nonvolatile, memory 630 can include volatile memory (e.g., the value or state of the data is indeterminate if power is interrupted to system 600). In one example, storage subsystem 680 includes controller 682 to interface with storage 684. In one example controller 682 is a physical part of interface 612 or processor 610 or can include circuits or logic in both processor 610 and interface 614.

A power source (not depicted) provides power to the components of system 600. More specifically, power source typically interfaces to one or multiple power supplies in system 600 to provide power to the components of system 600.

Examples of systems may be implemented in various types of computing, smart phones, tablets, personal computers, and networking equipment, such as switches, routers, racks, and blade servers such as those employed in a data center and/or server farm environment.

### EXAMPLES

A device can comprise: a substrate wherein the substrate comprises a first dielectric material; a first conductive region on the substrate wherein the first conductive region comprises tungsten; a second conductive region on the substrate wherein the first conductive region and the second conductive region each have a surface and the surface of the first conductive region and the surface of the second conductive region are in a same plane; a particle of tungsten wherein the particle of tungsten can have dimensions that are less than 30 nm; a second dielectric material, wherein the second dielectric material is different from the first dielectric material, wherein the second dielectric material is beneath the particle of tungsten, and wherein the second dielectric material is between the first conductive region and the second conductive region; and a layer of material on the surface of the first conductive region, on the surface of the second conductive region, and on the particle of tungsten, wherein the layer of material has a first surface that is in contact with the particle of tungsten, wherein the layer of material has a second surface opposite the first surface, and wherein the second surface is exposed. The particle of tungsten can have a dimension that is between 2 and 5 nm. The second dielectric material can be a low-κ dielectric material. The second dielectric material can be SiO₂, SiN, TiN, SiC, SiOₓC_{y}, SiOₓN_{y}, or SiCN. The layer of material can be comprised of TiN, Ta, aluminum oxide, or titanium oxide. The first dielectric material can be SiO₂, SiN, TiN, SiC, SiOₓC_{y}, SiOₓN_{y}, or SiCN. The substrate can also include transistors.

A device can comprise: a surface; a first conductive region comprising tungsten; a second conductive region; at least one spacer region wherein the spacer region is comprised of one or more layers of dielectric material and the spacer region is between the first conductive region and the second conductive region; a particle of tungsten wherein the particle of tungsten has dimensions that are less than 30 nm; a dielectric material region, wherein the dielectric material region is beneath the particle of tungsten and wherein the dielectric material region is not between the first conductive region and the second conductive region; and a layer of material on the surface and on the particle of tungsten, wherein the layer of material has a first surface that is in contact with the particle of tungsten, wherein the layer of material has a second surface opposite the first surface, and wherein the second surface is exposed. The particle of tungsten can have a dimension that can be between 2 and 5 nm. The dielectric material region can be comprised of a low-κ dielectric material. The dielectric material region can be comprised of SiO₂, SiN, TiN, SiC, SiOₓC_{y}, SiOₓN_{y}, or SiCN. The layer of material can be comprised of TiN, Ta, aluminum oxide, or titanium oxide. The spacer region can be comprised of SiO₂, SiN, TiN, SiC, SiOₓC_{y}, SiOₓN_{y}, and/or SiCN. The spacer region can be comprised of at least three layers of different materials.

A method for analyzing a surface of an integrated circuit device can comprise: etching a dielectric material from a surface of an integrated circuit device, wherein the surface comprises a conductive region comprising tungsten, wherein the surface comprises a tungsten nano-particle, and wherein the tungsten nano-particle has dimensions that are less than 30 nm; coating the surface of the integrated circuit device with a layer of material; and optically detecting a presence of the tungsten nano-particle wherein the tungsten nano-particle is between the surface of the integrated circuit device and the layer of material. The method can also include performing a chemical mechanical polish on the surface of the integrated circuit device. The particle of tungsten can have a dimension that is between 2 and 5 nm. The dielectric material can be comprised of a low-κ dielectric material. The layer of material can be comprised of TiN, Ta, aluminum oxide, or titanium oxide. The surface of the integrated circuit device can comprise a plurality of conductive regions separated by spacer regions wherein a spacer region is comprised of one or more layers of dielectric material.

Examples provide an integrated circuit comprising: one or more bodies comprising semiconductor material and extending in a first direction; a gate structure extending in a second direction over the one or more bodies; a layer comprising semiconductor material and extending in a third direction along a side of the one or more bodies and a side of the gate structure; and a source or drain region on the layer, such that the layer is between the source or drain region and the one or more bodies along the first direction, and the layer is between the source or drain region and the gate structure along the first direction.

In some examples the semiconductor material of the layer comprises silicon.

In some examples the layer has a thickness between about 1 nm and about 2 nm.

In some examples the layer contacts a bottom surface of the source or drain region.

In some examples the gate structure comprises a gate dielectric on the one or more semiconductor nanoribbons and a gate electrode on the gate dielectric, and the side of the one or more bodies is substantially coplanar with the side of the gate structure.

In some examples the gate dielectric directly contacts the layer.

Some examples further comprise spacer structures above the one or more bodies and on sidewalls of an upper portion of the gate structure.

In some examples the gate structure extends beneath the spacer structures along the first direction.

Examples provide an electronic device, comprising: a chip package comprising one or more dies, at least one of the one or more dies comprising: a semiconductor device having one or more semiconductor nanoribbons extending in a first direction, a source or drain region, and a gate structure extending in a second direction over the one or more semiconductor nanoribbons; and a semiconductor layer extending in a third direction along a side of the one or more semiconductor nanoribbons and a side of the gate structure, the side of the one or more semiconductor nanoribbons being substantially coplanar with the side of the gate structure, wherein the semiconductor layer is between the source or drain region and the one or more semiconductor nanoribbons along the first direction, and the semiconductor layer is between the source or drain region and the gate structure along the first direction.

In some examples the semiconductor layer contacts a bottom surface of the source or drain region.

In some examples the gate structure comprises: a gate dielectric on the one or more semiconductor nanoribbons; and a gate electrode on the gate dielectric.

In some examples the gate dielectric directly contacts the semiconductor layer.

In some examples the at least one of the one or more dies further comprises spacer structures on sidewalls of at least a top portion of the gate structure.

In some examples the gate structure extends beneath the spacer structures along the first direction.

An integrated circuit comprising: a first body of semiconductor material and a second body of semiconductor, each extending in a first direction; a gate structure extending in a second direction over the first and second bodies; a first layer of semiconductor material extending in a third direction along a first side of each of the first and second bodies and a first side of the gate structure; and a second layer of semiconductor material extending in the third direction along a second side of each of the first and second bodies and a second side of the gate structure; wherein the gate structure extends along the first direction between the first layer and the second layer and contacts both the first layer and the second layer.

In some examples the gate structure comprises: a gate dielectric on the first and second bodies; and a gate electrode on the gate dielectric.

In some examples the gate dielectric directly contacts both the first layer and the second layer.

Some example further comprise spacer structures on sidewalls of at least a top portion of the gate structure.

In some examples the gate structure extends beneath the spacer structures along the first direction.

In some examples the semiconductor material of the first body, the semiconductor material of the second body, the semiconductor material of the first layer, and the semiconductor material of the second layer are the same semiconductor material.

Besides what is described herein, various modifications can be made to what is disclosed and implementations without departing from their scope. Therefore, the illustrations and examples herein should be construed in an illustrative, and not a restrictive sense.

## Claims

1. A method comprising:
etching a dielectric material from a first surface of an integrated circuit device, to create an etched surface of the integrated circuit device, wherein the first surface comprises a conductive region comprising tungsten, wherein the first surface comprises a tungsten nano-particle, and wherein the tungsten nano-particle has dimensions that are less than 30 nm;
coating the etched surface of the integrated circuit device with a layer of coating material; and
optically detecting the tungsten nano-particle wherein the tungsten nano-particle is between the etched surface of the integrated circuit device and the layer of coating material.

2. The method of claim 1 also including performing a chemical mechanical polish on the first surface of the integrated circuit device.

3. The method of claim 1 wherein the particle of tungsten has a dimension that is between 2 and 5 nm.

4. The method of any of claims 1-3 wherein the layer of coating material is comprised of TiN, Ta, aluminum oxide, or titanium oxide.

5. A system comprising:
an optical scanner capable of optically scanning the surface of a semiconductor device;
a computing system comprising a processor; and
at least one machine-readable storage medium comprising non-transitory instructions,
that when executed by a processor, cause a system to:
optically scan a surface of a semiconductor device; and
determine the presence or absence of a tungsten nanoparticle wherein the tungsten nano-particle has dimensions that are less than 30 nm.

6. The system of claim 5 wherein the optical scanner provides bright-field or dark-field illumination.

7. The system of claim 5 wherein the tungsten nanoparticle has a dimension that is between 2 and 5 nm.

8. The system of claim 5 also comprising an etch process unit that is capable of performing a dry plasma etch or a wet chemical etch to remove a dielectric material.

9. The system of claim 5 also comprising a deposition unit that is capable of depositing a layer of material by physical vapor deposition, chemical vapor deposition, or atomic layer deposition.

10. The system of claim 5 also comprising a chemical mechanical polish unit.

11. The system of any of claims 5-10 wherein determining the presence or absence of a tungsten nanoparticle occurs through the comparison of a first die to a reference die.

12. At least one machine-readable storage medium comprising non-transitory instructions, that when executed by a processor, cause a system to:
etch a dielectric material from a surface of an integrated circuit device, wherein the surface comprises a tungsten nano-particle, and wherein the tungsten nano-particle has dimensions that are less than 30 nm, to create an etched surface on the integrated circuit device;
coat the etched surface of the integrated circuit device with a layer of coating material; and
optically detect the tungsten nano-particle wherein the tungsten nano-particle is between the etched surface of the integrated circuit device and the coating layer.

13. The at least one machine-readable storage medium of claim 12 wherein the particle of tungsten has a dimension that is between 2 and 5 nm.

14. The at least one machine-readable storage medium of claim 12 the layer of coating material is comprised of TiN, Ta, aluminum oxide, or titanium oxide.

15. The at least one machine-readable storage medium of any of claims 12-14 wherein the etch process is a plasma process or a chemical etch process.
